# EUROPEAN PATENT APPLICATION

(11) **EP 4 661 053 A1**
(43) Date of publication of application: **10.12.2025**
(21) Application number: 23919619.9
(22) Date of filing: 30.01.2023
(51) Int. Cl.: H01L 21/205

(54) **SUBSTRATE PROCESSING DEVICE, FURNACE OPENING ASSEMBLY, SUBSTRATE PROCESSING METHOD, METHOD OF MANUFACTURING SEMICONDUCTOR DEVICE, AND PROGRAM**

(71) Applicant: Kokusai Electric Corporation, Tokyo 101-0045 (JP)
(72) Inventor: TAKESHITA, Mitsunori, Toyama-shi, Toyama 939-2393 (JP); SHIMADA, Hironori, Toyama-shi, Toyama 939-2393 (JP); SAITO, Taisuke, Toyama-shi, Toyama 939-2393 (JP)
(74) Representative: Verscht, Thomas Kurt Albert
(86) International application number: PCT/JP2023/002918
(87) International publication number: WO 2024/161474

(57) **Abstract**

The present invention comprises a processing container which internally accommodates a substrate to be processed, a furnace opening member which has at least a portion facing an internal space of the processing container, a protection member which is provided so as to cover a portion which is of the furnace opening member and faces the internal space, and an attachment tool which applies a controlled predetermined pressure to the protection member to bring the protection member in contact with the portion facing the internal space and attaches the protection member to the furnace opening member.

## Description

### [Technical Field]

The present disclosure relates to a substrate processing apparatus, a furnace opening assembly, a substrate processing method, a method of manufacturing a semiconductor device and a program.

### [Related Art]

In a substrate processing of a manufacturing process of a semiconductor device, for example, a vertical type substrate processing apparatus may be used to simultaneously process a plurality of substrates. In such a vertical type substrate processing apparatus, particles may be generated due to by-products adhering to a lower portion of a process vessel (for example, Patent Document 1).

### [Related Art Document]

### [Patent Document]

Patent Document 1: Japanese Patent Laid-Open No. 2018-18882

### [Disclosure]

### [Technical Problem]

When particles are generated in a process vessel, the particles may adversely affect a film forming process.

According to the present disclosure, there is provided a technique capable of suppressing an adhesion of by-products to a lower portion of a process vessel.

### [Technical Solution]

According to an embodiment of the present disclosure, there is provided a technique that includes: a process vessel in which a substrate to be processed is capable of being accommodated; a furnace opening structure, wherein at least a portion of the furnace opening structure faces an inner space of the process vessel; a protective structure provided to cover the portion of the furnace opening structure facing the inner space; and a mounting fixture configured to bring the protective structure into contact with the portion of the furnace opening structure facing the inner space by applying thereto a regulated predetermined pressure and to attach the protective structure to the furnace opening structure.

### [Advantageous Effects]

According to some embodiments of the present disclosure, it is possible to suppress an adhesion of by-products to a lower portion of a process vessel.

### [Brief Description of Drawings]

FIG. 1 is a diagram schematically illustrating a vertical cross-section of a substrate processing apparatus preferably used in embodiments of the present disclosure.
FIG. 2 is a diagram schematically illustrating a top perspective view of a protective plate used in the substrate processing apparatus shown in FIG. 1.
FIG. 3 is a diagram schematically illustrating a bottom perspective view of the protective plate shown in FIG. 2.
FIG. 4 is a diagram schematically illustrating an enlarged vertical cross-section of an area around a stepped bolt configured to fix the protective plate shown in FIG. 2 to a lid.
FIG. 5 is a diagram schematically illustrating a vertical cross-section of an area around the stepped bolt shown in FIG. 4 according to a modified example.
FIG. 6 is a block diagram schematically illustrating a controller and its related components of the substrate processing apparatus preferably used in the embodiments of the present disclosure.
FIG. 7 is a diagram schematically illustrating a process flow according to the embodiments of the present disclosure.
FIG. 8 is a diagram schematically illustrating a gas flow around the protective plate during a flash purge.

### [Detailed Description]

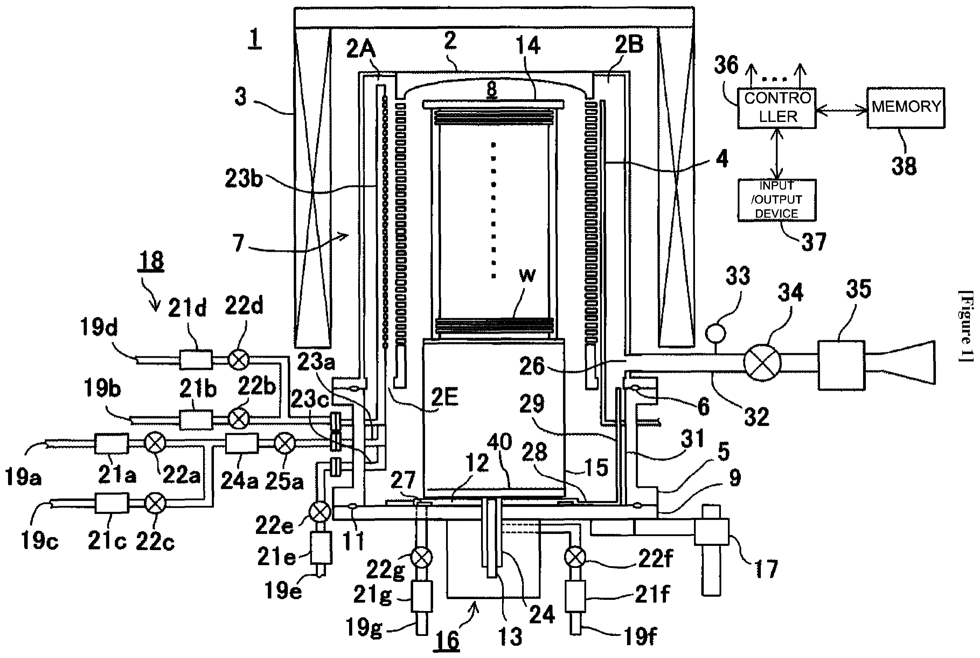

Hereinafter, embodiments of the technique of the present disclosure will be described in detail mainly with reference to FIGS. 1 to 8. The drawings used in the following descriptions are all schematic. For example, a relationship between dimensions of each component and a ratio of each component shown in the drawing may not always match the actual ones. In addition, even between the drawings, the relationship between the dimensions of each component and the ratio of each component may not always match. For components denoted by the same reference characters in two or more drawings, explanations thereof may be omitted. In addition, the number of each component described in the present specification is not limited to one, and the number of each component may be two or more unless otherwise specified in the present specification.

A substrate processing apparatus is configured as a vertical type substrate processing apparatus (hereinafter, also referred to as a "processing apparatus") 1 capable of performing a substrate processing (which is performed as a part of a manufacturing process in a method of manufacturing a semiconductor device) such as a heat treatment process.

As shown in FIG. 1, the processing apparatus 1 includes a reaction tube 2 of a cylindrical shape and a heater 3 serving as a heating structure (heating apparatus) installed on an outer periphery of the reaction tube 2. For example, the reaction tube 2 is made of a material such as quartz (SiO₂) and silicon carbide (SiC). A temperature sensor 4 is provided in the reaction tube 2. The temperature sensor 4 is installed upright (vertically) along an inner wall of the reaction tube 2.

A manifold 5 of a cylindrical shape is connected to a lower end opening of the reaction tube 2 via a seal 6 such as an O-ring, and configured to support a lower end of the reaction tube 2. For example, the manifold 5 is made of a metal such as stainless steel. A process vessel 7 is constituted by the reaction tube 2 and the manifold 5. A process chamber 8 (in which wafers W serving as substrates are processed) is formed (provided) inside the process vessel 7.

In addition, the reaction tube 2 is provided with a supply buffer chamber 2A and an exhaust buffer chamber 2B. The supply buffer chamber 2A and the exhaust buffer chamber 2B are provided opposite to each other and protrude outward (in a radial direction). Each of the supply buffer chamber 2A and the exhaust buffer chamber 2B is divided into a plurality of spaces by partition walls. Nozzles 23a, 23b and 23c extending in a stacking direction of the wafers W are installed in each compartment (space) of the supply buffer chamber 2A. The supply buffer chamber 2A serves as a nozzle arrangement structure capable of accommodating the nozzles 23a to 23c in positions that do not interfere with the wafers W. Boundary walls are provided between the supply buffer chamber 2A and the process chamber 8 and between the exhaust buffer chamber 2B and the process chamber 8. An inner diameter of each boundary wall is substantially the same as an inner diameter of the reaction tube in locations where the supply buffer chamber 2A and the like are not provided. Each boundary wall is provided with a plurality of slits so as to communicate with portions related thereto. An opening 2E is formed at a bottom of an inner wall of the supply buffer chamber 2A so as to insert and remove the nozzles 23a to 23c. A width of the opening 2E is set to be substantially the same as a width of the supply buffer chamber 2A. In the present embodiments, since it is difficult to eliminate a gap between the opening 2E and a base of the nozzles 23a to 23c, it is difficult to prevent an outflow of a reactive gas and the like through the gap.

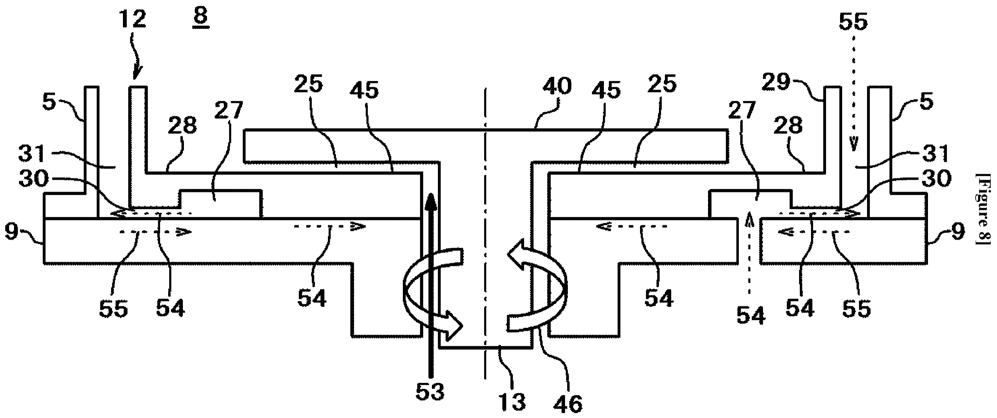

A lower end opening of the manifold 5 (that is, a lower end opening of the process vessel 7) is opened and closed by a lid (which is a furnace opening structure or a seal cap) 9 of a disk shape. In other words, the lid 9 airtightly closes the lower end opening of the process vessel 7. Thereby, it is possible to maintain the process chamber 8 airtight. At least a portion of the lid 9 is exposed to an atmosphere (inner atmosphere) of the process vessel 7. For example, the lid 9 is made of a metal material. A seal 11 such as an O-ring is installed on an upper surface of the lid 9, and the seal 11 is configured to airtightly seal the reaction tube 2 from an outside air. A protective plate (protective structure) 12 serving as a lid cover is installed on the upper surface of the lid 9. In other words, the protective plate 12 is installed so as to cover the portion of the lid 9 exposed to the inner atmosphere of the process vessel 7. A hole 46 (see FIG. 8) described later is formed in a center of the lid 9, and a rotating shaft 13 is inserted through the hole 46. To protect the seal 6 or the seal 11, it is preferable to maintain a temperature of the seal 6 or the seal 11 at 200 °C or less, and a water jacket (not shown) may be attached to a flange of the reaction tube 2 or a flange of the manifold 5.

The process chamber 8 is configured to accommodate a boat 14 serving as a substrate retainer. The boat 14 is configured to support the plurality of wafers (for example, 25 wafers to 150 wafers) W while the wafers W are stacked vertically in shelf-like manner. For example, the boat 14 is made of a material such as quartz and SiC, and is supported above a thermal insulation structure (thermal insulation assembly) 15. The thermal insulation structure 15 is provided at a position closer to the wafer W to be processed than the protective plate 12.

An outer shape of the thermal insulation structure 15 is cylindrical, and the thermal insulation structure 15 is supported by the rotating shaft 13 penetrating the lid 9. The thermal insulation structure 15 includes a bottom plate 40 (which is of a disk shape) made of a metal and supported by the rotating shaft 13. The rotating shaft 13 is connected to a rotator 16 installed below the lid 9. For example, a magnetic fluid seal is provided at a portion of the rotating shaft 13 that penetrates the lid 9, and the rotating shaft 13 is configured to be rotatable while hermetically sealing an inside (inner portion) of the reaction tube 2. By rotating the rotating shaft 13, the thermal insulation structure 15 and the boat 14 are rotated together. The lid 9 is driven in an up-down direction by a boat elevator 17 serving as an elevator. By elevating or lowering the substrate retainer and the lid 9 together by the boat elevator 17, the boat 14 is transferred (loaded) into or transferred (unloaded) out of the reaction tube 2.

The process apparatus 1 includes a gas supply structure 18 configured to supply a source gas, the reactive gas or an inert gas into the process chamber 8. The source gas, the reactive gas and the inert gas serve as process gases used for the substrate processing. The process gas supplied through the gas supply structure 18 is selected in accordance with a type of a film to be formed. The gas supply structure 18 may include a source gas supplier, a reactive gas supplier, an inert gas supplier, a first purge gas supplier and a second purge gas supplier.

The source gas supplier includes a gas supply pipe 19a. A mass flow controller (MFC) 21a serving as a flow rate controller (flow rate control structure), a valve 22a serving as an opening/closing valve, a tank 24a and a valve 25a are sequentially installed at the gas supply pipe 19a in this order from an upstream side to a downstream side of the gas supply pipe 19a. A downstream end of the gas supply pipe 19a is connected to the nozzle 23a which penetrates a side wall of the manifold 5. The nozzle 23a is installed upright in the reaction tube 2 in the up-down direction along the inner wall of the reaction tube 2, and is provided with a plurality of supply holes which open toward the wafers W accommodated in the boat 14. The source gas is supplied to the wafers W through the supply holes of the nozzle 23a. A flash flow supplier is constituted mainly by the gas supply pipe 19a, the MFC 21a, the valve 22a, the tank 24a, the valve 25a and the nozzle 23a.

Similarly, the reactive gas is supplied to the wafers W from the reactive gas supplier through a gas supply pipe 19b, an MFC 21b, a valve 22b and the nozzle 23b. The inert gas is supplied to the wafers W from the inert gas supplier through a gas supply pipe 19c, an MFC 21c, a valve 22c, the tank 24a, the valve 25a and the nozzle 23a. In addition, the inert gas is also supplied to the wafers W from the inert gas supplier through gas supply pipes 19d and 19e, MFCs 21d and 21e, valves 22d and 22e, and the nozzles 23b and 23c. A flash purge supply path (which is a third purge gas) is constituted mainly by the gas supply pipe 19c, the MFC 21c, the valve 22c, the tank 24a, the valve 25a and the nozzle 23a.

The first purge gas supplier (first purge gas supply structure) includes a gas supply pipe 19f. A mass flow controller (MFC) 21f and a valve 22f are sequentially installed at the gas supply pipe 19f in this order from an upstream side to a downstream side of the gas supply pipe 19f. A downstream end of the gas supply pipe 19f is connected to a hollow structure (which is a hollow portion) 24 formed around the rotating shaft 13. The hollow structure 24 is sealed in front of a bearing by the magnetic fluid seal, and is open at an upper end thereof, that is, open to the inside of the reaction tube 2. In addition, a space is formed to extend from the hollow structure 24 to an upper surface of the protective plate 12. The space is continuous with a gap formed between the bottom plate 40 of the thermal insulation structure 15 and the protective plate 12. Thereby, a first purge gas flow path 25 (see FIG. 8) is provided. In addition, the rotating shaft 13 is also provided with a hollow structure. A first purge gas is introduced into the rotating shaft 13 through a through hole provided on a side of the rotating shaft 13 in vicinity of the magnetic fluid seal, and then into the thermal insulation structure 15.

The second purge gas supplier (second purge gas supply structure) includes a gas supply pipe 19g. A mass flow controller (MFC) 21g and a valve 22g are sequentially installed at the gas supply pipe 19g in this order from an upstream side to a downstream side of the gas supply pipe 19g. A downstream end of the gas supply pipe 19g penetrates the lid 9. Thereby, a second purge gas supply port is formed on the upper surface of the lid 9. Thus, the second purge gas supply port is formed on the upper surface of the lid 9 and opens into a second purge gas flow path 27. The second purge gas supply port is open toward the nozzles 23a to 23c. A flexible pipe such as a bellows pipe is used for the gas supply pipe 19a between the valve 22g and the second purge gas supply port. The second purge gas flow path (purge gas supply path) 27 is of a substantially annular shape (loop shape), and is formed around an entire circumference of a lower surface of the protective plate 12.

An exhaust pipe 32 is provided at an exhaust port 26 of the reaction tube 2. A vacuum pump 35 serving as a vacuum exhaust apparatus is connected to the exhaust pipe 32 via a pressure sensor 33 serving as a pressure detector (pressure detection structure) configured to detect a pressure (inner pressure) of the process chamber 8 and an APC (Automatic Pressure Controller) valve 34 serving as a pressure regulator (which is a pressure adjusting structure or an adjusting valve whose opening degree can be adjusted). With such a configuration, it is possible to set the inner pressure of the process chamber 8 to a process pressure in accordance with a processing. The exhaust pipe 32 is installed at a location opposite to the nozzles 23a to 23c. An exhauster (which is an exhaust system or an exhaust structure) is constituted mainly by the exhaust pipe 32, the APC valve 34 and the pressure sensor 33. The exhauster may further include the vacuum pump 35.

For example, the protective plate 12 provided on the upper surface of the lid 9 may be made of a heat resistant and corrosion resistant material (a corrosion resistant material) such as quartz. By covering the lid 9 made of the metal material with the protective plate 12, it is possible to prevent (suppress) the process gas from coming into contact with the lid 9. Thereby, it is possible to prevent (suppress) a corrosion or a deterioration of the lid 9 due to the process gas.

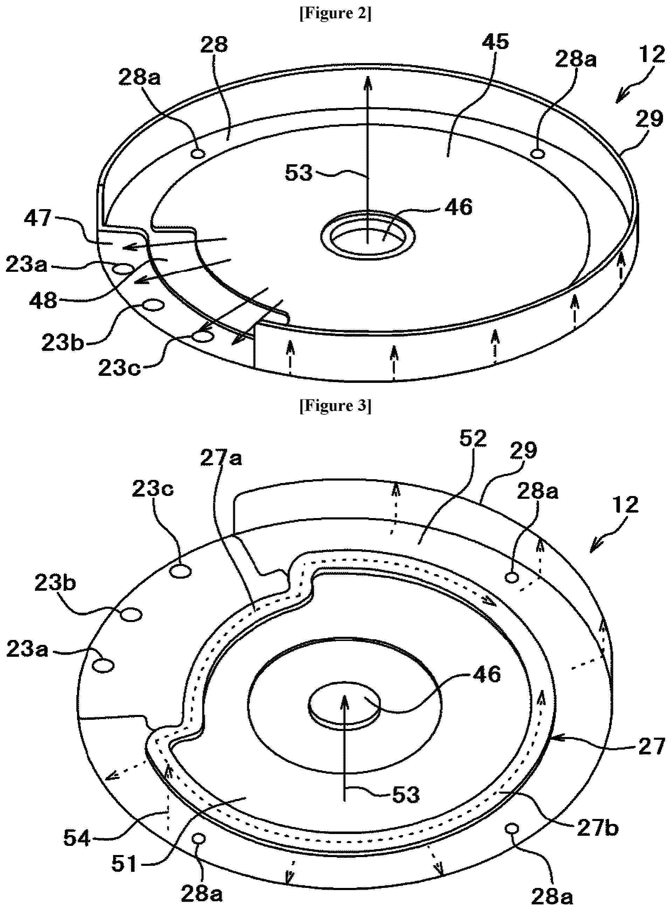

Hereinafter, a structure of the protective plate 12 configured to supply the first purge gas 53 intensively to the base of the nozzles 23a to 23c and to supply a second purge gas 54 to the other portions will be described with reference to FIGS. 2 and 3. In addition, in FIGS. 2 and 3, a flow of the first purge gas 53 is indicated by solid arrows, and a flow of the second purge gas 54 is indicated by dashed arrows. In addition, in FIGS. 2 and 3, the nozzles 23a to 23c (that is, installation positions of the nozzles 23a to 23c) are shown as holes for convenience.

As shown in FIG. 2, a thick structure 45, a first thin structure 28, a second thin structure 47 and a third thin structure 48 are formed on a surface of the protective plate 12. The thick structure 45 is of a substantially circular shape with a portion thereof cut out, and the hole 46 is provided in a central portion thereof. The rotating shaft 13 is inserted through the hole 46. In addition, a disk structure of a disk shape is constituted by the thick structure 45, the first thin structure 28, the second thin structure 47 and the third thin structure 48.

The first thin structure 28 is formed on an outer periphery of the thick structure 45. In other words, the first thin structure 28 is located outer than an outer periphery of the bottom plate 40 of the thermal insulation structure 15 when viewed from a central axis of the process vessel 7. A thickness of the first thin structure 28 is set to be smaller than that of the thick structure 45, and is of an annular shape with a portion thereof cut out. In addition, a side wall structure (side wall portion) 29 is formed vertically and continuously along an outer peripheral end of the first thin structure 28. The first thin structure 28 is provided with a plurality of mounting holes 28a through which screws can be inserted. That is, the mounting holes 28a are arranged outside an outer peripheral end of a bottom of the thermal insulation structure 15. The cut-out portion of the first thin structure 28 forms the second thin structure 47 thinner than the first thin structure 28. The second thin structure 47 is formed in a location corresponding to the installation positions of the base of the nozzles 23a to 23c and peripheries thereof (opening 2E). In addition, the side wall structure 29 is not formed on an outer peripheral end of the second thin structure 47.

The cut-out portion of the thick structure 45 forms the third thin structure 48 thinner than the thick structure 45. A thickness of the third thin structure 48 is set to be the same or substantially the same as that of the first thin structure 28. The third thin structure 48 extends continuously with the second thin structure 47 along a radially direction of the second thin structure 47. The third thin structure 48 is constituted by an arc-shaped structure concentric with the second thin structure 47. A width of the third thin structure 48 is set to a predetermined width. In addition, preferably, the thickness of the third thin structure 48 is set to be thicker than a thickness of the second thin structure 47. With such a configuration, it is possible to reduce a flow resistance from a central portion of the protective plate 12 toward the nozzles 23a to 23c. In other words, it is possible to increase a supply amount of the first purge gas 53 from the central portion of the protective plate 12 toward the nozzles 23a to 23c.

Therefore, since a concentration of the process gas at the base of the nozzles 23a to 23c and the peripheries thereof can be reduced, it is possible to suppress an adhesion of by-products. Thereby, it is possible to suppress a generation of particles, and it is also possible to improve the productivity.

In addition, an outer diameter of the bottom plate 40 is set to be smaller than an outer diameter of the thick structure 45, and a position of an inner peripheral end of the third thin structure 48 is set to be closer to a center of the protective plate 12 than an inner peripheral end of the bottom plate 40. Thus, a gap formed between the bottom plate 40 and the third thin structure 48 is greater than a gap formed between the bottom plate 40 and the thick structure 45. Thereby, a flow resistance of the first purge gas flow path 25 in the gap between the bottom plate 40 and the third thin structure 48 is smaller than that in the gap between the bottom plate 40 and the thick structure 45.

In addition, by line-connecting two ends of an area (where a concentration of the source gas or the reactive gas is high and where the first purge gas 53should be supplied more intensively) with the center of the protective plate 12, a fan-shaped area is formed, and the second thin structure 47 and the third thin structure 48 are located within the fan-shaped area. For example, a central angle (opening angle) α of the fan-shaped area is 60°, and is appropriately set within a range of "0° < α < 120°" depending on the number of nozzles installed and the like. In addition, when the central angle α exceeds 120°, the concentration of the process gas may exceed a critical value, and the by-products may adhere to the inside of the process vessel 7, which is not preferable.

For example, the second thin structure 47 and the third thin structure 48 are formed at positions facing the exhaust port 26 (opposite to the exhaust port 26).

As shown in FIG. 3, a groove 27 (hereinafter, also referred to as the "second purge gas flow path 27") of a predetermined width and a predetermined depth is provided on a back surface of the thick structure 45 along an outer peripheral end of the thick structure 45. The second purge gas flow path 27 is constituted by: a first flow path 27a curved in a circumferential direction and extending along the inner peripheral end of the third thin structure 48; and a second flow path 27b of a ring shape curved outward in the radial direction at a side end of the third thin structure 48 and curved further in the circumferential direction along the outer peripheral end of the thick structure 45. The second flow path 27b extends along the outer peripheral end of the thick structure 45, and is continuous with the first flow path 27a.

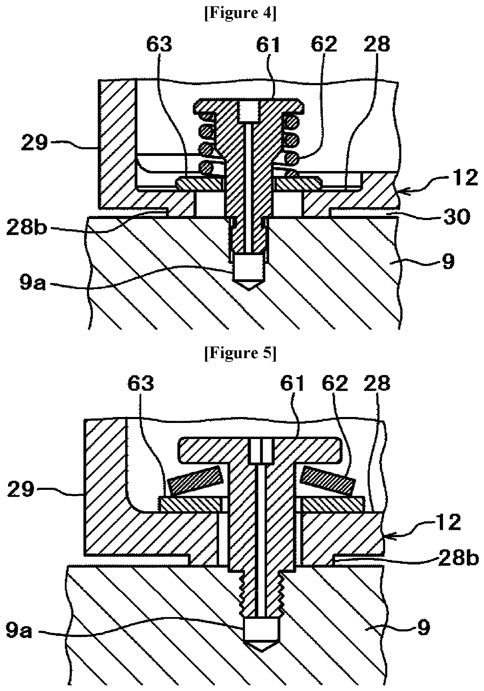

On a back surface of the protective plate 12, a stepped structure (stepped portion) 52 is formed on a back surface of the first thin structure 28 to be located outer than an outer periphery of the second purge gas flow path 27 to reduce the thickness thereof. Therefore, when the protective plate 12 is installed on the lid 9, a central portion 51 (that is, the back surface of the thick structure 45) located closer to the center of the protective plate 12 than the second purge gas flow path 27 comes into contact with the upper surface of the lid 9, and a gap 30 of a predetermined thickness is formed between the upper surface of the lid 9 and the stepped structure 52. However, the first thin structure 28 around the mounting holes 28a includes a protrusion (protruding structure) 28b (see FIG. 4) protruding toward the lid 9 and coming into a surface contact with the upper surface of the lid 9. In other words, the protective plate 12 is of a plate shape, and is provided so as to form the gap of a predetermined thickness between the protective plate 12 and at least a part of a surface of the portions of the lid 9 exposed to the inner atmosphere of the process vessel 7, and so as to come into a surface contact with the lid 9 at a surface of other portion of the lid 9. Thereby, it is possible to prevent the protective plate 12 from floating up (being lifted up) and moving even when the purge gas is flowing. In addition, the stepped structure 52 that reduces the thicknesses does not extend to back surfaces of the second thin structure 47 and the third thin structure 48 on the back surface of the protective plate 12.

The gas supply pipe 19g of the second purge gas supplier communicates with the second flow path 27b, and the second purge gas 54 is supplied through the second flow path 27b. The second purge gas 54 supplied to the second flow path 27b flows through the second flow path 27b and then the first flow path 27a, and also flows through the second flow path 27b. At this time, the upper surface of the lid 9 comes into contact with the central portion 51, and the gap 30 is formed between the upper surface of the lid 9 and the stepped structure 52. Therefore, when flowing through the first flow path 27a and the second flow path 27b, the second purge gas 54 flows out of the gap 30, flows through a gap 31 between an inner peripheral surface of the manifold 5 and the side wall structure 29, and is ejected to a furnace opening while purging. The second purge gas 54 ejected to the furnace opening is exhausted through the exhaust port 26.

By forming the side wall structure 29, it is possible to reduce a cross-sectional area of a flow path of the second purge gas 54. Thereby, it is possible to sufficiently purge the inner peripheral surface of the manifold 5 while suppressing a supply amount of the second purge gas 54, and it is also possible to significantly reduce the concentration of the process gas. As a result, it is possible to suppress the adhesion of the by-products to the inner peripheral surface of the manifold 5 and the generation of the particles, and it is also possible to improve the productivity.

In addition, the gap 30 connecting the first flow path 27a and the second flow path 27b to the furnace opening maintains a constant size along an entire circumference thereof by the stepped structure 52. Therefore, the purge gas can flow relatively uniformly to the furnace opening at least in the second flow path 27b. On the other hand, the length of the gap along the first flow path 27a is about half of the length of the gap along the second flow path 27b. Thereby the conductance is reduced in the first flow path 27a, thereby decreasing outflow of the purge gas. Since an amount of the first purge gas 53 increased by the third thin structure 48 is greater than an amount of the above-discussed decrease in the outflow of the purge gas, it is possible to enhance a supply of the purge gas to the base of the nozzles 23a to 23c. An end of the gap between the bottom plate 40 and the third thin structure 48 is open so as to face the opening 2E provided at the bottom of the supply buffer chamber 2A. Thereby, it is possible to prevent the protective plate 12 from floating (being lifted) up even in a structure prone to a flash inflow of the purge gas.

A method of attaching (fixing) the protective plate 12 to the lid 9 will be described with reference to FIGS. 4 and 5. A furnace opening assembly is constituted by the lid 9, the protective plate 12 and a mounting fixture described later. The protective plate 12 is fixed to the lid 9 by inserting stepped bolts (which are or screws) 61 into the mounting holes 28a provided in the first thin structure 28, respectively. At this time, the protrusion 28b is in a surface contact with the upper surface of the lid 9. In addition, the mounting holes 28a are located outside the outer periphery of the bottom plate 40 of the thermal insulation structure 15 when viewed from the central axis of the process vessel 7. Thereby, it is possible to install the stepped bolt 61 (which protrudes upward) without changing the gap with the thermal insulation structure 15.

The stepped bolt 61 is provided with a cylindrical structure that is not threaded on a head thereof, and is threaded on a front end (tip) thereof. A spring washer (spring) 62 serving as an elastic structure is inserted between a lower surface of the head of the stepped bolt 61 and a surface of the first thin structure 28 of the protective plate 12 (that is, into a circular head). In addition, a spring (washer) 63 is inserted between the spring washer 62 and the surface of the first thin structure 28. The mounting fixture (which is a fixture) is constituted by the stepped bolt 61, the spring washer 62 and the washer 63. In addition, the lid 9 is provided with a female threaded structure (screw hole) 9a into which a male threaded structure of the stepped bolt 61 is screwed.

The washer 63 is provided with a function of preventing the spring washer 62 from coming into direct contact with the surface of the first thin structure 28. In addition, the washer 63 is sufficiently thick to prevent a deformation of the washer 63 itself. Further, in order to disperse a force transmitted from the spring washer 62 to the first thin structure 28 over a surface area of the washer 63 such that the force is transmitted to the surface of the first thin structure 28 as a surface stress without generating a point stress, the surface area of the washer 63 is preferably as large as possible within a range of a installation space thereof. Since the washer 63 applies a surface load, it is possible to prevent the generation of the particles due to a friction.

A spring force (that is, a spring constant) of the spring washer 62 is set by taking into consideration a lifting force caused by an ejection of the second purge gas 54 generated at a bottom surface of the first thin structure 28, and also by taking into consideration a strength of the first thin structure 28. In addition, the stepped bolt 61 is fully tightened to the lid 9. Thereby, it is possible to manage a pressing force regardless of a tightening torque of the stepped bolt 61.

In general, a spring washer is often used for tightening. In such a case, when tightening a non-stepped screw (bolt) to a point at which the bolt can no longer be tightened, the spring washer is compressed to a point at which the spring washer will not deform any further (that is, there is no room for contraction). In such a state, a tightening force of the screw is directly transmitted to a target component. In other words, the pressing force is determined by the tightening force of the screw, regardless of an elasticity of the spring. Therefore, the pressing force cannot be controlled.

Therefore, according to the present embodiments, the spring washer 62 is configured to press and hold the protective plate 12 with a regulated predetermined spring force (pressure) rather than being in a completely tightened state. In other words, the mounting fixture attaches the protective plate 12 to the lid 9 by applying the regulated predetermined pressure that exceeds the gravity. Thereby, it is possible to install the lid 9 without damage, and it is also possible to prevent the protective plate 12 from floating (being lifted) or moving due to a pressure fluctuation.

Each of the stepped bolt 61 and the washer 63 may be made of a metal material or a non-metal material (such as a resin). It is preferable to select material that ensures a sufficient strength and is suitable for an environment in which the stepped bolt 61 and the washer 63 will be used. The spring washer 62 is made of a metal material. As long as spring characteristics can be obtained, a shape of the spring washer 62 does not matter, such as a coil-wound type (compression coil) shown in FIG. 4, a disk spring type shown in FIG. 5, or a wave spring type (not shown). A displacement range of the spring washer 62 is large and the pressing force of the spring washer 62 can be easily controlled as compared with a typical C-shaped spring washer.

Preferably, each of the stepped bolt 61, the washer 63 and the spring washer 62 may be made of a corrosion resistant material such as a nickel-based alloy (such as Hastelloy). When using such a material, a surface thereof is finished by an electrolytic composite polishing to minimize a surface roughness. Thereby, it is possible to suppress the corrosion and the generation of the particles.

The pressing force is less affected by tolerances and can be controlled with greater precision when the spring constant is smaller (when an amount of the displacement is larger). However, a screw head will protrude farther. Therefore, as the stepped bolt 61 and the spring washer 62, it is preferable to use custom-made products rather than general-purpose products in order to obtain an appropriate accuracy in a limited installation space.

The number of fastenings (such as the number of the stepped bolts 61 and the number of the mounting holes 28a) is determined by calculating a weight of the protective plate 12 and the force (lifting force) applied to the protective plate 12 and comparing it with the holding force. In other words, a plurality of mounting fixtures including the mounting fixture mentioned above are provided, and the protective plate 12 is attached to the lid 9 by applying a predetermined pressure in the same direction at a plurality of locations corresponding to the mounting fixtures to bring the protective plate 12 into contact with the lid 9. Thereby, since the pressure is distributed, it is possible to prevent a partial lifting. In addition, it is also possible to place the stepped bolt 61 in the vicinity of a location where the lifting force is generated. It is preferable that the number of the mounting holes 28a is three or more. In addition, it is also possible for the protective plate 12 to be lifted up from the lid 9 by an external force exceeding a predetermined pressure (for example, a pressure on the back surface of the protective plate 12).

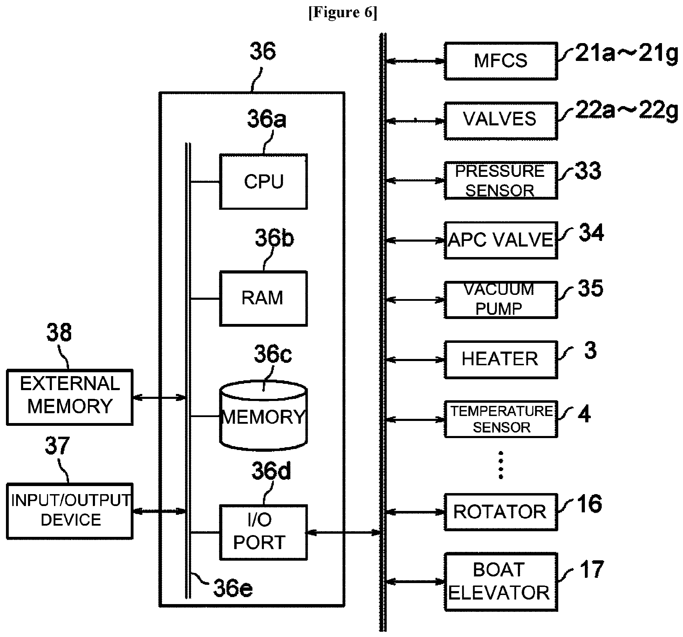

As shown in FIG. 6, a controller 36 serving as a control structure (control apparatus) is c onstituted by a computer including a CPU (Central Processing Unit) 36a, a RAM (Random Access Memory) 36b, a memory 36c and an I/O port (input/output port) 36d. The RAM 36b, the memory 36c and the I/O port 36d are configured to be capable of changing data with the CPU 36a through an internal bus 36e. For example, an input/output device 37 constituted by a component such as a touch panel is connected to the controller 36. In addition, the controller 36 is configured to be capable of being connected to an external memory 38.

For example, the memory 36c is configured by a component such as a flash memory, a hard disk drive (HDD) and a solid state drive (SSD). For example, a control program configured to control an operation of the processing apparatus 1 and a process recipe containing information on procedures and conditions of the substrate processing described later may be readably stored in the memory 36c. The process recipe is obtained by combining steps (procedures) of the substrate processing described later such that the controller 36 can execute the steps to acquire a predetermined result, and functions as a program. Hereinafter, the process recipe and the control program may be collectively or individually referred to as a "program". In addition, the process recipe may also be simply referred to as a "recipe". Thus, in the present specification, the term "program" may refer to the recipe alone, may refer to the control program alone or may refer to both of the recipe and the control program. The RAM 36b functions as a memory area (work area) where a program or data read by the CPU 36a is temporarily stored.

The I/O port 36d is connected to the components described above such as the MFCs 21a to 21g, the valves 22a to 22g, the pressure sensor 33, the APC valve 34, the vacuum pump 35, the temperature sensor 4, the heater 3, the rotator 16 and the boat elevator 17.

The CPU 36a is configured to read the control program from the memory 36c and execute the control program read from the memory 36c. In addition, the CPU 36a is configured to read the recipe from the memory 36c, for example, in accordance with an operation command inputted from the input/output device 37. In accordance with contents of the recipe read from the memory 36c, the CPU 36a is configured to be capable of controlling various operations such as flow rate adjusting operations for various substances (various gases) by the MFCs 21a to 21g and opening and closing operations of the valves 22a to 22g. In addition, in accordance with the contents of the recipe read from the memory 36c, the CPU 36a is configured to be capable of controlling various operations such as an opening and closing operation of the APC valve 34 and a pressure regulating operation (pressure adjusting operation) by the APC valve 34 based on the pressure sensor 33, a start and stop operation of the vacuum pump 35, a temperature regulating operation (temperature adjusting operation) by the heater 3 based on the temperature sensor 4. In addition, in accordance with the contents of the recipe read from the memory 36c, the CPU 36a is configured to be capable of controlling various operations such as an operation of adjusting a rotation and a rotation speed of the boat 14 by the rotator 16 and an elevating and lowering operation of the boat 14 by the boat elevator 17.

The controller 36 may be embodied by installing the above-described program stored in the external memory 38 into the computer. For example, the external memory 38 may include a magnetic disk such as the HDD, an optical disk such as a CD, a magneto-optical disk such as an MO and a semiconductor memory such as a USB memory and the SSD. The memory 36c or the external memory 38 may be embodied by a non-transitory computer readable recording medium. Hereafter, the memory 36c and the external memory 38 may be collectively or individually referred to as a "recording medium". Thus, in the present specification, the term "recording medium" may refer to the memory 36c alone, may refer to the external memory 38 alone, or may refer to both of the memory 36c and the external memory 38. Instead of the external memory 38, a communication interface such as the Internet and a dedicated line may be used for providing the program to the computer.

### (2) Substrate Processing

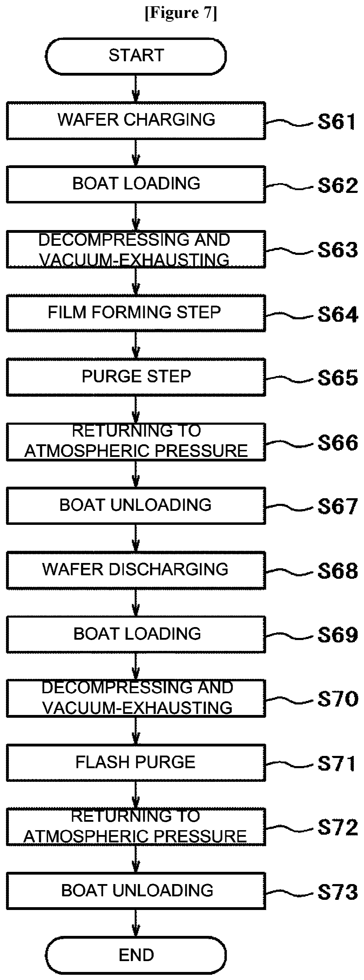

Hereinafter, an example of a method of processing the substrate by using the processing apparatus 1 described above, which is a part of a manufacturing process of a semiconductor device, that is, forming a predetermined film on a surface of the wafer W serving as the substrate, will be described with reference to FIG. 7. In addition, in the following description, operations of components constituting the processing apparatus 1 are controlled by the controller 36.

In the present specification, the term "wafer" may refer to "a wafer itself", or may refer to "a wafer and a stacked structure (aggregated structure) of a predetermined layer (or layers) or a film (or films) formed on a surface of the wafer". In the present specification, the term "a surface of a wafer" may refer to "a surface of a wafer itself", or may refer to "a surface of a predetermined layer (or a predetermined film) formed on a wafer". Thus, in the present specification, the term "forming a predetermined layer (or a film) on a wafer" may refer to "forming a predetermined layer (or a film) directly on a surface of a wafer itself", or may refer to "forming a predetermined layer (or a film) on a surface of another layer (or another film) formed on a wafer". In the present specification, the terms "substrate" and "wafer" may be used as substantially the same meaning. In the present specification, the term "process temperature" refers to a temperature of the wafer W or a temperature (inner temperature) of the process chamber 8.

### <Wafer Charging: S61 and Boat Loading: S62>

When the plurality of wafers W are loaded (charged) into the boat 14 (wafer charging), the boat 14 is transferred (loaded) into the process chamber 8 by the boat elevator 17 (boat loading), and a lower portion of the reaction tube 2 and therebelow are airtightly closed (sealed) by the lid 9. At this time, the first purge gas 53 is supplied through the first purge gas supplier to the base of the nozzles 23a to 23c via the first purge gas flow path 25 (which is the gap) in the third thin structure 48. In addition, the second purge gas 54 is supplied through the second purge gas supplier to the gap between the side wall structure 29 and the manifold 5 via the second purge gas flow path 27. The first purge gas 53 and the second purge gas 54 are continuously supplied at least until a film forming process is completed. In the present embodiments, for example, as the first purge gas 53 and the second purge gas 54, nitrogen (N₂) gas serving as the inert gas may be used.

### <Decompressing and Vacuum-exhausting: S63>

The process chamber 8 is vacuum-exhausted (decompressed and exhausted) by the vacuum pump 35 such that the inner pressure of the process chamber 8 reaches and is maintained at a desired process pressure (vacuum degree). The inner pressure of the process chamber 8 is measured by the pressure sensor 33, and the APC valve 34 is feedback-controlled based on pressure information measured by the pressure sensor 33. In addition, the heater 3 heats the wafer W in the process chamber 8 such that the temperature of the wafer W in the process chamber 8 reaches and is maintained at a desired process temperature. At this time, a state of electric conduction to the heater 3 is feedback-controlled based on temperature information detected by the temperature sensor 4 such that a desired temperature distribution of the inner temperature of the process chamber 8 can be obtained. In addition, the rotator 16 starts rotating the boat 14 and the wafer W.

### <Film Forming Process: S64>

### <Source Gas Supply Step>

When the inner temperature of the process chamber 8 is stabilized at the process temperature (which is set in advance), the source gas is supplied to the wafer W in the process chamber 8. After a flow rate of the source gas is controlled by the MFC 21a to a desired flow rate, the source gas whose flow rate is controlled is supplied into the process chamber 8 through the gas supply pipe 19a and the nozzle 23a. At this time, the inert gas is supplied to the furnace opening through the first purge gas supplier and the second purge gas supplier. Thereby, it is possible to intensively purge the base of the nozzles 23a to 23c and the peripheries thereof with the first purge gas 53, and it is also possible to purge the other portions with the second purge gas 54. As a result, it is possible to dilute the concentration of the source gas at the furnace opening. In addition, in the present step, a supply of the inert gas through the first purge gas supplier and the second purge gas supplier may be temporarily increased.

### <Source Gas Exhaust Step>

Subsequently, a supply of the source gas is stopped, and the process chamber 8 is vacuum-exhausted by the vacuum pump 35. At this time, the inert gas may be supplied into the process chamber 8 through the inert gas supplier (inert gas purge). In the present step, for example, the N₂ gas may be used as the inert gas.

### <Reactive Gas Supply Step>

Subsequently, the reactive gas is supplied to the wafer W in the process chamber 8. After a flow rate of the reactive gas is controlled by the MFC 21b to a desired flow rate, the reactive gas whose flow rate is controlled is supplied into the process chamber 8 through the gas supply pipe 19b and the nozzle 23b. At this time, the inert gas is supplied to the furnace opening through the first purge gas supplier and the second purge gas supplier. Thereby, it is possible to intensively purge the base of the nozzles 23a to 23c and the peripheries thereof, and it is also possible to purge the other portions. As a result, it is possible to dilute the concentration of the reactive gas at the furnace opening.

### <Reactive Gas Exhaust Step>

Subsequently, a supply of the reactive gas is stopped, and the process chamber 8 is vacuum-exhausted by the vacuum pump 35. At this time, the inert gas may be supplied into the process chamber 8 through the inert gas supplier (inert gas purge).

By performing a cycle of performing the four steps mentioned above a predetermined number of times (once or more times), it is possible to form, on the wafer W, a film of a predetermined composition and a predetermined thickness.

### <Purge Step: S65 and Returning to Atmospheric Pressure: S66>

After the film forming step is completed, the inert gas serving as the purge gas is supplied through each of the nozzles 23a to 23c into the process chamber 8 and exhausted through the exhaust pipe 32 via the exhaust port 26. Thereby, an inside of the process chamber 8 is purged, and a substance such as a residual gas remaining in the process chamber 8 and the by-products remaining in the process chamber 8 can be removed from the process chamber 8 (after-purge). Thereafter, the inner atmosphere of the process chamber 8 is replaced with the inert gas (substitution by inert gas), and the inner pressure of the process chamber 8 is returned to a normal (returning to atmospheric pressure).

### <Boat Unloading: S67 and Wafer Discharging: S68>

Thereafter, the lid 9 is lowered by the boat elevator 17, and the boat 14 is transferred (unloaded) from the reaction tube 2 (boat unloading). Thereafter, the wafers W which are processed are removed from the boat 14 (wafer discharging).

By performing the step S68, the film forming process is completed. However, after the film forming process, a maintenance process is periodically performed to remove the by-products accumulated in a furnace and the nozzles. The maintenance process will be described below.

### <Boat Loading: S69>

The boat 14 in which the wafer W is not loaded (charged) is transferred (loaded) into the process chamber 8 by the boat elevator 17 (boat loading), and the lower portion of the reaction tube 2 and therebelow are airtightly closed (sealed) by the lid 9. At this time, the first purge gas 53 is supplied through the first purge gas supplier to the base of the nozzles 23a to 23c via the first purge gas flow path 25 (which is the gap) in the third thin structure 48. In addition, the second purge gas 54 is supplied through the second purge gas supplier to the gap 31 between the side wall structure 29 and the manifold 5 via the second purge gas flow path 27. In the present embodiments, for example, as the first purge gas 53 and the second purge gas 54, the nitrogen (N₂) gas serving as the inert gas may be used.

### <Decompressing and Vacuum-exhausting: S70>

The process chamber 8 is vacuum-exhausted (decompressed and exhausted) by the vacuum pump 35 such that the inner pressure of the process chamber 8 reaches and is maintained at a desired process pressure (vacuum degree). The inner pressure of the process chamber 8 is measured by the pressure sensor 33, and the APC valve 34 is feedback-controlled based on the pressure information measured by the pressure sensor 33.

### <Flash Purge Step: S71>

The inert gas serving as the purge gas is instantaneously supplied through the inert gas supplier into the process chamber 8 via the gas supply pipes 19c to 19e, the MFCs 21c to 21e, the valves 22c to 22e and the nozzles 23a to 23c in a large amount (that is, in a flash supply manner), and is exhausted through the exhaust pipe 32 via the exhaust port 26. Thereby, the inside of the process chamber 8 is purged, and the substance such as the residual gas remaining in the process chamber 8 and the by-products remaining in the process chamber 8 can be removed from the process chamber 8 (flash purge). At this time, the first purge gas 53 is instantaneously supplied through the first purge gas supplier to the base of the nozzles 23a to 23c via the first purge gas flow path 25 (which is the gap) in the third thin structure 48 in a large amount. In addition, the second purge gas 54 is instantaneously supplied through the second purge gas supplier to the gap between the side wall structure 29 and the manifold 5 via the second purge gas flow path 27 in a large amount.

In addition, a third purge gas 55 is instantaneously supplied through the third purge gas supplier to the process chamber 8 in a large amount. A method of supplying the third purge gas 55 will be described. First, with the valves 22a and 25a closed, the valve 22c is opened to supply the inert gas into the gas supply pipes 19c and 19a. After a flow rate of the inert gas is adjusted by the MFC 21c, the inert gas whose flow rate is adjusted is supplied to the tank 24a and stored in the tank 24a. After a predetermined amount of the inert gas has been stored in the tank 24a at a predetermined pressure, the valve 22c is closed, and the inert gas is contained (confined) in the tank 24a. By performing a series of operations mentioned above, an operation of filling the tank 24a with the inert gas is completed. Thereafter, while maintaining the valve 22c closed, the valve 25a is opened. As a result, the inert gas of a high pressure stored in the tank 24a is supplied at once (in a pulse-wise manner) into the process chamber 8 through the gas supply pipe 19a and the nozzle 23a.

A gas flow during the flash purge will be described using FIG. 8. The first purge gas 53 serving as a flash purge gas supplied through the first purge gas supplier flows upward around an outer periphery of the rotating shaft 13, then turns horizontally and is supplied to a lower portion of the process vessel 7, which is the furnace opening, while purging the first purge gas flow path 25 (which is the gap between the bottom plate 40 and the protective plate 12). That is, the first purge gas 53 purges a periphery of the rotating shaft 13 in a upstream thereof, and purges the exposed surface of the protective plate 12 and the base of the nozzles 23a to 23c in a downstream thereof, and is finally discharged (exhausted through the exhaust port 26 formed at the lower end of the reaction tube 2.

The first thin structure 28 extending to the vicinity of the manifold 5 (except for a portion where the nozzles 23a to 23c are arranged) is provided at the protective plate 12. In addition, the side wall structure 29 extending vertically along the inner wall of the manifold 5 is provided at the outer peripheral end of the first thin structure 28. The gap 30 of a predetermined size is formed between the first thin structure 28 and the lid 9, and the gap 31 of a predetermined size is formed between the side wall structure 29 and the manifold 5.

The second purge gas 54 serving as the flash purge gas supplied to the second purge gas flow path 27 flows outward in the radial direction through the second purge gas flow path 27, passes through the gap 31 to purge the back surface of the protective plate 12 or an inner surface of the manifold 5, and is then exhausted through the exhaust port 26. At this time, the pressure on the back surface of the protective plate 12 is instantaneously elevated above a pressure (inner pressure) of the furnace.

When the protective plate 12 is not fixed to the lid 9, the protective plate 12 may rotate or float (be lifted) due to the pressure on the back surface of the protective plate 12. In addition, in such a case, the second purge gas 54 flows out in the radially outward direction through the second purge gas flow path 27, and is exhausted to the hole 46 through a gap between the back surface of the protective plate 12 and the upper surface of the lid 9.

However, according to the present embodiments, since the protective plate 12 is fixed to the lid 9, it is possible to suppress a rotation and a floating (movement) of the protective plate 12. Thereby, it is possible to reduce a damage such as a crack and a chipping (fragment) caused by the movement of the protective plate 12. In addition, the pressure on the back surface of the protective plate 12 is preferably controlled to a predetermined pressure. That is, the predetermined pressure is preferably set to prevent the protective plate 12 from float up (being lifted) from the lid 9 when the flash supply is performed.

In addition, the third purge gas 55 supplied through the nozzle 23a serving as the flash purge supply path may be introduced into the second purge gas flow path 27 through the gaps 31 and 30. However, an effect thereof is small.

### <Returning to Atmospheric Pressure: S72>

After the flash purge process, the inner atmosphere of the process chamber 8 is replaced with the inert gas (substitution by inert gas), and the inner pressure of the process chamber 8 is returned to the normal pressure (returning to atmospheric pressure).

### <Boat Unloading: S73>

Thereafter, the lid 9 is lowered by the boat elevator 17, and the boat 14 is transferred (unloaded) from the reaction tube 2 (boat unloading).

In general, in order to prevent a metal contamination to the wafer in a reaction furnace (process vessel), instead of a metal component, components such as a quartz component and a ceramic component are installed inside the reaction furnace. A heavyweight component and a lightweight component may exist among the components installed inside the reaction furnace. Usually, the quartz component or the ceramic component is not fixed using a fastening structure such as a screw and a bolt because the quartz component or the ceramic component is prone to crack and chipping. Therefore, the quartz component or the ceramic component is simply placed in a designated place inside the reaction furnace.

However, inside the reactor, a gas flow or a pressure fluctuation may occur. When the gas is supplied at a large flow rate or when the pressure fluctuation is large, in a case where the quartz component or the ceramic component is the lightweight component, the lightweight component may move horizontally in a front-rear and left-right direction or may float (be lifted) up. As a result, the damage such as the crack and the chipping may occur. When the crack or the chipping occurs inside the reactor, the particles may be generated. As a result, a decrease in the productivity and a yield may occur.

According to the present embodiments, the protective plate 12 (which is the quartz component prone to crack and chipping) is maintained to be unmoved. Thereby, it is possible to fix the protective plate 12 without cracking or chipping.

In addition, in the embodiments mentioned above, the flash purge is described as an example in which the gas is supplied at a large flow rate or in which the pressure fluctuation is large. However, such a gas supply in large amount or such a large pressure fluctuation may occur in the following cases. Even in such cases, since the pressure on the back surface of the protective plate 12 is controlled to a predetermined pressure, it is possible to prevent the protective plate 12 from floating (being lifted) up.
(1) In a case where the gas is exhausted with the APC valve 34 fully open while the gas remains in the process vessel 7 (sudden pressure reduction).
(2) In a case where the flash flow supplier is included, wherein the flash flow supplier is configured to supply the gas in a flash flow manner through the nozzle 23a into the process vessel 7 by opening the valve 25a serving as an opening/closing valve provided in the gas supply pipe (piping) 19a connecting the tank 24a and the process vessel 7 in a state where the gas is stored in the tank 24a configured to store the process gas (for example, the source gas).

For example, the embodiments mentioned above are described by way of an example in which a batch type substrate processing apparatus configured to simultaneously process a plurality of substrates is used. However, the technique of the present disclosure is not limited thereto. For example, the technique of the present disclosure may be preferably applied to, for example, a single wafer type substrate processing apparatus configured to process one or several substrates at a time, by installing a protective structure at a bottom of a process chamber thereof. In addition, the technique of the present disclosure may be widely applied to a substrate processing apparatus, regardless of whether it is a hot wall type substrate processing apparatus or a cold wall type substrate processing apparatus.

### [Description of Reference Numerals]

| | | | |
|---|---|---|---|
| 7 | Process vessel | 9 | Lid (furnace opening structure) |
| 12 | Protective plate (protective structure) | | |

## Claims

1. A substrate processing apparatus comprising:
a process vessel in which a substrate to be processed is capable of being accommodated;
a furnace opening structure, wherein at least a portion of the furnace opening structure faces an inner space of the process vessel;
a protective structure provided to cover the portion of the furnace opening structure facing the inner space; and
a mounting fixture configured to bring the protective structure into contact with the portion of the furnace opening structure facing the inner space by applying thereto a regulated predetermined pressure and to attach the protective structure to the furnace opening structure.

2. The substrate processing apparatus of claim 1, wherein the protective structure is provided with a purge gas supply path through which a purge gas is supplied to a gap of a predetermined height, wherein the gap of the predetermined height is formed between the protective structure and at least a part of a surface of the portion of the furnace opening structure facing the inner space, and the protective structure is in a surface contact with other part of the surface of the portion of the furnace opening structure facing the inner space.

3. The substrate processing apparatus of claim 1, wherein a plurality of mounting fixtures are provided,
wherein the plurality of mounting fixtures are configured to bring the protective structure into contact with the furnace opening structure by applying the predetermined pressure in a same direction at a plurality of locations corresponding thereto, and to attach the protective structure to the furnace opening structure such that the protective structure is capable of being lifted up from the furnace opening structure by an external force exceeding the predetermined pressure.

4. The substrate processing apparatus of claim 1, further comprising:
an exhauster comprising an adjusting valve whose opening degree is variable, and configured to be capable of exhausting the process vessel with the adjusting valve fully open in a state where a gas remains in the process vessel; or
a flash purge supply path configured to be capable of supplying a purge gas into the process vessel in a flash supply manner,
wherein the predetermined pressure is set to prevent the protective structure from being lifted up from the furnace opening structure when the purge gas is supplied in the flash supply manner or when the adjusting valve is open.

5. The substrate processing apparatus of claim 1, further comprising:
a flash flow supplier comprising: a tank configured to store a process gas; and an opening/closing valve provided in a pipe connecting the tank and the process vessel, and configured to be capable of supplying the process gas into the process vessel in a flash flow manner with the opening/closing valve open in a state where the process gas is stored in the tank,
wherein the predetermined pressure is set to prevent the protective structure from being lifted up from the furnace opening structure when the process gas is supplied in the flash flow manner with the opening/closing valve open.

6. The substrate processing apparatus of claim 1, wherein the mounting fixture comprises a spring.

7. The substrate processing apparatus of claim 1, wherein the furnace opening structure is a lid configured to airtightly close a lower end opening of the process vessel.

8. The substrate processing apparatus of claim 4, further comprising:
a thermal insulation assembly provided at a position closer to the substrate to be processed than the protective structure,
wherein a gap is provided between the protective structure and a bottom of the thermal insulation assembly,
wherein the flash purge supply path is provided with a nozzle extending in a stacking direction of the substrate in the process vessel,
wherein the process vessel is provided with a nozzle arrangement structure capable of accommodating the nozzle in a position that does not interfere with the substrate, and
wherein an end of the gap is open so as to face toward a direction in which the nozzle arrangement structure opens in the process vessel.

9. The substrate processing apparatus of claim 1, wherein the mounting fixture comprises:
a screw configured to be inserted into a mounting hole provided in the protective structure and to screw into a screw hole provided in the furnace opening structure;
an elastic structure through which the screw is inserted; and
a washer through which the screw is inserted, and provided between the elastic structure and the protective structure.

10. The substrate processing apparatus of claim 9, wherein the screw, the elastic structure and the washer are made of a nickel-based alloy of a same composition.

11. The substrate processing apparatus of claim 9, wherein the elastic structure is at least one of a compression coil spring, a disk spring or a wave spring washer.

12. The substrate processing apparatus of claim 9, wherein the screw is a stepped bolt capable of being completely fastened to the furnace opening structure.

13. The substrate processing apparatus of claim 1, wherein the protective structure is provided with three or more mounting holes with which the mounting fixture is respectively engaged, and
wherein a protrusion protruding toward the furnace opening structure and provided with a contact surface contacting the furnace opening structure is provided around the three or more mounting holes.

14. The substrate processing apparatus of claim 13, further comprising
a thermal insulation assembly provided at a position closer to the substrate to be processed than the protective structure,
wherein the mounting holes are located outside an outer periphery of a bottom of the thermal insulation assembly when viewed from a central axis of the process vessel.

15. A furnace opening assembly of a substrate processing apparatus, the furnace opening assembly comprising:
a lid configured to close a lower end opening of a process vessel in which a substrate is processed, wherein the lid is at least partially exposed to an inner atmosphere of the process vessel;
a protective structure provided to cover a portion of the lid facing an inner space of the process vessel; and
a mounting fixture configured to bring the protective structure into contact with the portion of the lid facing the inner space by applying a regulated predetermined pressure and to attach the protective structure to the furnace opening structure.

16. A substrate processing method comprising:
a step of loading a substrate into a substrate processing apparatus, wherein the substrate processing apparatus comprises: a process vessel in which the substrate to be processed is capable of being accommodated; a furnace opening structure, wherein at least a portion of the furnace opening structure faces an inner space of the process vessel; a protective structure arranged to cover the portion of the furnace opening structure facing the inner space; and a mounting fixture configured to bring the protective structure into contact with the portion of the furnace opening structure facing the inner space by applying a regulated predetermined pressure and to attach the protective structure to the furnace opening structure; and
a step of processing the substrate.

17. A method of manufacturing a semiconductor device, comprising:
a step of loading a substrate into a substrate processing apparatus, wherein the substrate processing apparatus comprises: a process vessel in which the substrate to be processed is capable of being accommodated; a furnace opening structure, wherein at least a portion of the furnace opening structure faces an inner space of the process vessel; a protective structure arranged to cover the portion of the furnace opening structure facing the inner space; and a mounting fixture configured to bring the protective structure into contact with the portion of the furnace opening structure facing the inner space by applying a regulated predetermined pressure and to attach the protective structure to the furnace opening structure; and
a step of processing the substrate.

18. A program that causes, by a computer, a substrate processing apparatus to perform:
a sequence of loading a substrate into a substrate processing apparatus, wherein the substrate processing apparatus comprises: a process vessel in which the substrate to be processed is capable of being accommodated; a furnace opening structure, wherein at least a portion of the furnace opening structure faces an inner space of the process vessel; a protective structure arranged to cover the portion of the furnace opening structure facing the inner space; and a mounting fixture configured to bring the protective structure into contact with the portion of the furnace opening structure facing the inner space by applying a regulated predetermined pressure and to attach the protective structure to the furnace opening structure; and
a sequence of processing the substrate.
